# EUROPÄISCHE PATENTANMELDUNG

(11) **EP 3 715 351 A1**
(43) Veröffentlichungstag der Anmeldung: **30.09.2020**
(21) Anmeldenummer: 19165935.8
(22) Anmeldetag: 28.03.2019
(51) Int. Cl.: C07F 15/00, C07F 5/00, C23C 16/18, C23C 16/455

(54) **METALLKOMPLEXE FÜR GASPHASEN-DÜNNSCHICHTABSCHEIDUNG**

(71) Anmelder: UMICORE AG & CO. KG, 63457 Hanau-Wolfgang (DE)
(72) Erfinder: SUNDERMEYER, Joerg, 35041 Marburg (DE); Schumann, Henrik, 35796 Weinbach (DE); SCHORN, Wolf, 76337 Waldbronn (DE); RAU, Nicholas, 35039 Marburg (DE); FREY, Annika, 63457 Hanau (DE); KARCH, Ralf, 63801 Kleinosthelm (DE); WOERNER, Eileen, 61130 Nidderau (DE); DOPPIU, Angelino, 63500 Seligenstadt (DE)
(74) Vertreter: Clauswitz, Kai-Uwe Wolfram

(57) **Zusammenfassung**

Es werden Metallkomplexe der Formel (I) beschrieben:

[M(L¹)ₓ(L²)_{y} (hydra)_{z}]ₙ Formel (I)

wobei:
M
= Metallatom mit einer Ordnungszahl ausgewählt aus den Bereichen a) bis c):
a) 12, 21 bis 34, mit Ausnahme von 30,
b) 39 bis 52, mit Ausnahme von 48,
c) 71 bis 83, mit Ausnahme von 80,

L¹
= neutraler oder anionischer Ligand, mit x = 0 oder 1,
L²
= neutraler oder anionischer Ligand, mit y = 0 oder 1,
(hydra)
= Acetondimethylhydrazon-Monoanion, mit z = 1, 2 oder 3,
n
= 1 oder 2 ist, und
die Gesamtladung des Komplexes 0 ist.

## Beschreibung

Die Erfindung betrifft Metallkomplexe mit Acetondimethylhydrazon-Liganden. Die Erfindung betrifft außerdem Verfahren zur Herstellung der Metallkomplexe und Verwendungen der Metallkomplexe in CVD-Verfahren und ALD-Verfahren. Die Erfindung betrifft zudem Verfahren, in denen die Metallkomplexe als Präkursor eingesetzt werden, sowie mit den Metallkomplexen erhältliche metallisierte Oberflächen.

### Stand der Technik

Die Oberfläche eines Substrats kann auf verschiedene Arten metallisiert werden. Die Oberfläche eines Substrates kann zum Beispiel mittels Gasphasen-Dünnschichtabscheidung metallisiert werden. Beispielhafte Gasphasen-Dünnschichtabscheidungen sind das CVD-Verfahren (CVD = *chemical vapor deposition*) und das ALD-Verfahren (ALD = *atomic layer deposition*). In diesen Verfahren wird ein Metall aus der Gasphase auf einer Oberfläche eines Substrats abgeschieden.

In der Gasphase liegt das Metall typischerweise als gasförmige Vorläufersubstanz vor. Solche Vorläufersubstanzen werden auch als Präkursoren bezeichnet wird. Aufgrund des Einsatzes in der Gasphase sollten die Präkursoren möglichst flüchtig sein. Als Präkursoren für Metalle werden oftmals Metallkomplexe eingesetzt.

Als Präkursoren zur Abscheidung von beispielsweise Ruthenium oder Indium sind etwa (Methylcyclopentadienyl)₂Ru, (Dimethylpentadienyl)₂Ru, (Aren)Ru(1,4-diaza-1,3-butadien), Me₃In und [3-Dimethylamino)propyl]dimethylindiumprinzipiell geeignet. Die bekannten Präkursoren weisen verschiedene Nachteile auf. (Methylcyclopentadienyl)₂Ru ist beispielsweise thermisch vergleichsweise stabil und lässt keine hohen Abscheidungsraten von Ruthenium zu. Diese Präkursoren können zudem zu einem Einbau von Kohlenstoff führen.

Für Präkursoren für die Abscheidung von Metallen auf Substratoberflächen mittels Gasphasen-Dünnschichtabscheidung besteht insgesamt noch Verbesserungsbedarf. Einige der bekannten Präkursoren weisen eine zu geringe synthetische Zugänglichkeit auf. Einige der bekannten Präkursoren weisen zu hohe Zersetzungstemperaturen auf. Einige der bekannten Präkursoren weisen zu hohe Einbauraten von Kohlenstoff und anderer Verunreinigungen bei der Herstellung dünner Metallschichten auf. Bei einigen der bekannten Präkursoren kommt es zu einer bevorzugten Abspaltung nur eines schwach gebundenen Liganden. Diese Präkursoren sind daher für ALD-Verfahren ungeeignet. Einige der bekannten Präkursoren sind zu wenig flüchtig und/oder bei Raumtemperatur nicht flüssig.

Bei einer industriellen Anwendung ist es zudem von großem Interesse, dass bei der Synthese von Präkursoren für Metalle möglichst wenige Stufen zum gewünschten Produkt führen. Bei der Synthese sollten harsche Reaktionsbedingungen vermieden werden. Die Präkursoren sollten in möglichst hohen Ausbeuten erhalten werden. Die Präkursoren sollten bei Raumtemperatur lange haltbar sein. Die Präkursoren sollten ein Erwärmen eines Vorratsgefäßes für Gasphasen-Dünnschichtverfahren wie etwa eines sogenannten Bubblers auf Temperaturen bis 100°C zwecks Erhöhung des Dampfdruckes überstehen. Die Präkursoren sollten unter typischen Bedingungen von Gasphasen-Dünnschichtverfahren wie insbesondere bei erhöhten Temperaturen exotherm zerfallen.

Fujisawa et al. beschreiben Cuprate mit Acetondimethylhydrazon-Liganden und Lithium oder Magnesiumbromid als kationischer Spezies.^{[1]} Diese wurden nur *in situ* als Reaktanten bei der Synthese von 7-Oxo-(E)-3-Alkansäuren durch Umsetzung mit β-Vinyl-β-propiolacton gebildet. Cárdenas et al. beschreiben Palladiumkomplexe mit Acetophenondimethylhydrazon-, Triphenylphosphin- und Halogenidoliganden.^{[2]} S. Javed et al. beschreiben Zink- und Aluminiumkomplexe mit Acetondimethylhydrazon-Liganden.^{[3],[4]} Das Zersetzungsverhalten dieser Komplexe, insbesondere bei Thermolyse, wurde nicht untersucht. Komplexe von Acetondimethylhydrazon-Liganden mit anderen Metallen können eine unerwünschte reduktive Eliminierung der Acetondimethylhydrazon-Liganden erfahren. Daraus resultiert regelmäßig ein instabiler Komplex.

### Aufgabe der Erfindung

Der Erfindung liegt die Aufgabe zugrunde, Metallkomplexe bereitzustellen, welche die oben beschriebenen Nachteile zumindest teilweise und möglichst ganz überwinden.

Der Erfindung liegt insbesondere die Aufgabe zugrunde, Metallkomplexe bereitzustellen, welche die oben beschriebenen vorteilhaften Eigenschaften aufweisen. Die Metallkomplexe sollen eine hohe Flüchtigkeit aufweisen. Die Metallkomplexe sollen bei Raumtemperatur möglichst flüssig sein. Die Metallkomplexe sollen bei höheren Temperaturen noch stabil sein. Die Metallkomplexe sollen keine zu hohen Zersetzungstemperaturen haben.

Aufgabe der Erfindung ist auch, eine gute synthetische Zugänglichkeit der Metallkomplexe zu gewährleisten, insbesondere über Synthesen mit wenigen Stufen. Aufgabe der Erfindung ist es dabei auch, dass die Synthese der Metallkomplexe keine harschen Reaktionsbedingungen erfordert und möglichst hohe Ausbeuten liefert.

### Offenbarung der Erfindung

Überraschenderweise werden die der Erfindung zugrunde liegenden Aufgaben gelöst durch Metallkomplexe gemäß den Patentansprüchen.

Gegenstand der Erfindung ist ein Metallkomplex der Formel (I):

[M(L¹)ₓ(L²)_{y}(hydra)_{z}]ₙ Formel (I)

wobei:
- M =: Metallatom mit einer Ordnungszahl ausgewählt aus den Bereichen a) bis c):
a) 12, 21 bis 34, mit Ausnahme von 30,
b) 39 bis 52, mit Ausnahme von 48,
c) 71 bis 83, mit Ausnahme von 80,
- L¹ =: neutraler oder anionischer Ligand, mit x = 0 oder 1,
- L² =: neutraler oder anionischer Ligand, mit y = 0 oder 1,
- (hydra) =: Acetondimethylhydrazon-Monoanion, mit z = 1, 2 oder 3, und
- n =: 1 oder 2 ist, und
die Gesamtladung des Komplexes 0 ist.

Für das Metallatom M gibt die Ordnungszahl wie in der Chemie üblich die Stellung des Metallatoms M im Periodensystem der Elemente an. Die mit den Bereichen a) bis c) definierten Ordnungszahlen bzw. Metalle sind entsprechend die folgenden:
a) 12 (Mg), 21 (Sc), 22 (Ti), 23 (V), 24 (Cr), 25 (Mn), 26 (Fe), 27 (Co), 28 (Ni), 29 (Cu), 31 (Ga), 32 (Ge), 33 (As) und 34 (Se);
b) 39 (Y), 40 (Zr), 41 (Nb), 42 (Mo), 43 (Tc), 44 (Ru), 45 (Rh), 46 (Pd), 47 (Ag), 49 (In), 50 (Sn), 51 (Sb) und 52 (Te);
c) 71 (Lu), 72 (Hf), 73 (Ta), 74 (W), 75 (Re), 76 (Os), 77 (Ir), 78 (Pt), 79 (Au), 81 (TI), 82 (Pb) und 83 (Bi).
Erfindungsgemäß hat das Metallatom M nicht die Ordnungszahl 30 (Zn; M ist nicht Zink), nicht die Ordnungszahl 48 (Cd; M ist nicht Cadmium) und nicht die Ordnungszahl 80 (Hg; M ist nicht Quecksilber).

Das Metallatom M kann verschiedene Oxidationsstufen aufweisen, bevorzugt die Oxidationsstufe +I, +II, +III, +IV, +V, +VI oder +VII. Das Metallatom ist formal positiv geladen und kann mit M^{a+} angegeben werden, wobei a = 1, 2, 3, 4, 5, 6 oder 7 ist. Erfindungsgemäß ist es bevorzugt, dass die Oxidationsstufe +I, +II, +III oder +IV beträgt bzw. a = 1, 2, 3 oder 4 ist. Erfindungsgemäß ist es bevorzugt, dass das Metallatom M unter Standardbedingungen mit mindestens zwei unterschiedlichen Oxidationsstufen stabil vorliegen kann.

L¹ und L² sind unabhängig voneinander neutrale oder anionische Liganden, aber keine Metalle, insbesondere nicht Li oder Mg. Wenn L¹ bzw. L² ein neutraler Ligand ist, beträgt seine Oxidationsstufe ±0. L¹ bzw. L² ist dann formal ungeladen. Wenn L¹ bzw. L² ein anionischer Ligand ist, beträgt seine Oxidationsstufe bevorzugt -I oder -II, mehr bevorzugt -I. Der Ligand L¹ bzw. L² ist dann formal negativ geladen und kann mit (L¹)^{b1-} bzw. (L²)^{b2-} angegeben werden, wobei b1, b2 = 1 oder 2 und bevorzugt 1 ist. L¹, L², x und y sind unabhängig voneinander so ausgewählt, dass der Metallkomplex der Formel (I) neutral ist.

Bei n = 1 ist der erfindungsgemäße Metallkomplex ein mononuklearer Metallkomplex mit einem Metallatom M.

Bei n = 2 ist der erfindungsgemäße Metallkomplex ein dinuklearer Metallkomplex mit zwei Metallatomen M. Die zwei Metallatome weisen bevorzugt die gleiche Ordnungszahl auf. Der Metallkomplex ist in so einem Fall ein homodinuklearer Metallkomplex.

Die Gesamtladung des Metallkomplexes ist 0 (null), d.h. der Metallkomplex ist elektrisch neutral. Die Neutralität des Metallkomplexes spiegelt sich im Fehlen einer Ladungsangabe an der eckigen Klammer wider.

Der Ligand (hydra) ist ein Acetondimethylhydrazon-Monoanion. (hydra) ist also ein von Acetondimethylhydrazon durch Deprotonierung abgeleitetes Monoanion. Die negative Ladung des Monoanions ist in (hydra) delokalisiert. (hydra) wird hier teilweise auch mit "[hydra](1-)" oder "Hydra" bezeichnet. Acetondimethylhydrazon wird hier teilweise auch mit "H-hydra" bezeichnet.

Wenn in einem (hydra)-Metallkomplexe neben (hydra) noch ein weiterer Ligand "R" vorliegt, kann es zu einer reduktiven Eliminierung kommen. Dabei wird (hydra) zusammen mit R als R-(hydra) abgespalten. Gleichzeit wird das zurückbleibende Metallatom reduziert. Dabei gehen zwei negative Ladungen auf das Metallatom über. Ein entsprechendes Metall weist daher regelmäßig mindestens zwei stabile Oxidationsstufen auf, deren Differenz zwei Ladungen beträgt.

Bekannte Metallkomplexe mit dem Liganden (hydra) werden von Metallen gebildet, die keine zwei stabilen Oxidationsstufen aufweisen, deren Differenz zwei Ladungen beträgt, oder deren d-Schale voll besetzt ist (Li, Al und Zn). Derartige (hydra)-Metallkomplexe neigen nicht zu einer reduktiven Eliminierung von (hydra). Entsprechend ist eine Stabilität derartiger Komplexe zu erwarten.

Im Gegensatz dazu ist für (hydra)-Metallkomplexe von Metallen mit mindestens zwei stabilen Oxidationsstufen mit einer Differenz von zwei Ladungen und/oder mit nicht abgeschlossener d-Schale eine Neigung zu reduktiver Eliminierung von (hydra) zu erwarten. Entsprechend war im Stand der Technik für solche (hydra)-Metallkomplexe eine schwierige Darstellbarkeit und eine geringe Stabilität zu erwarten.

Überraschend wurde im Rahmen der vorliegenden Erfindung gefunden, dass auch (hydra)-Metallkomplexe von derartigen Metallen mit Ordnungszahlen aus den Bereichen a), b) und c) leicht dargestellt werden können. Überraschend wurde im Rahmen der vorliegenden Erfindung auch gefunden, dass die erfindungsgemäßen (hydra)-Metallkomplexe stabil sind, insbesondere keinem spontanen Zerfall unterliegen.

Für erfindungsgemäße Metallkomplexe spielt die reduktive Eliminierung ferner bei einer erzwungenen Zersetzung, insbesondere einer Thermolyse, der Metallkomplexe eine Rolle. Liganden eines (meta)stabilen Metallkomplexes werden bei einer erzwungenen Zersetzung des Metallkomplexes regelmäßig als Radikal abgespalten. Dies ist zum Beispiel regelmäßig für Cyclopentadienylliganden der Fall. Für den Liganden (hydra) werden andere Fragmentierungswege erwartet. Ohne Bindung an die Theorie wird im Rahmen der vorliegenden Erfindung angenommen, dass der Ligand (hydra) bei Zersetzung der erfindungsgemäßen Metallkomplexe eine leichte Spaltung der N-N-Bindung im Ligandrückgrat ermöglicht.

Insbesondere wird bei Zersetzung des erfindungsgemäßen Metallkomplexes eine reduktive Eliminierung des Liganden (hydra) erwartet. Insbesondere bei Thermolyse eines erfindungsgemäßen Metallkomplexes kann es zu einer reduktiven Eliminierung des Liganden (hydra) kommen.

In dem erfindungsgemäßen Metallkomplex liegt ein Ligand (hydra) neben mindestens einem weiteren Liganden R vor. (hydra) kann zusammen mit dem mindestens einen weiteren Liganden R reduktiv eliminiert werden. R ist vorzugsweise H, Alkyl oder auch (hydra). Bei einer Zersetzung bzw. Thermolyse kann es zu einer reduktiven Eliminierung von R-(hydra) gemäß folgendem Schema kommen:

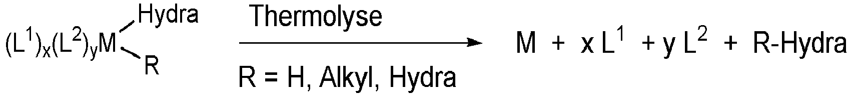

Die reduktive Eliminierung bildet einen selektiven, thermischen Zerfallsweg. Durch die reduktive Eliminierung von R-hydra wird M reduziert. M kann metallisch abgeschieden werden. Aufgrund dieses angenommenen Zerfallswegs sind die erfindungsgemäßen Metallkomplexe für Gasphasen-Dünnschichtverfahren zur Metallisierung von Substratoberflächen besonders geeignet.

Die erfindungsgemäßen Metallkomplexe umfassen Komplexe der Übergangsmetalle. Diese Metallkomplexe werden von Übergangsmetallatomen M mit einer Ordnungszahl von 21 bis 29, 39 bis 47 oder 71 bis 79 gebildet. Besonders bevorzugte Metallatome sind dabei Ti, Co, Ru, Pd, Ir und Au. Diese Übergangsmetallatome weisen unbesetzte oder partiell besetzte d-Orbitale auf. D.h., die Übergangsmetallatome haben eine d-Elektronenkonfiguration von d⁰ bis d⁹. Für erfindungsgemäße Komplexe mit den genannten Übergangsmetallen wird ein selektiver, thermischer Zerfall über reduktive Eliminierung von R-Hydra erwartet.

Übergangsmetalle mit voll besetzter d-Schale, d.h. mit einer d¹⁰-Elektronenkonfiguration, sind erfindungsgemäß nicht umfasst. Ohne Bindung an die Theorie wird davon ausgegangen, dass sich (hydra)-Metallkomplexe von Übergangsmetallen mit d¹⁰-Elektronenkonfiguration aufgrund ihrer abgeschlossenen stabilen d¹⁰-Schale ähnlich verhalten wie (hydra)-Metallkomplexe von Hauptgruppenmetalle der 2. und 3. Periode, insbesondere von Li und Al. Derartige (hydra)-Metallkomplexe gehen regelmäßig keine reduktive Eliminierung von R-(hydra) ein. Für (hydra)-Metallkomplexe mit dem Übergangsmetall Zink, M = Zn mit d¹⁰-Elektronenkonfiguration, sind entsprechend weder reduktive Eliminierungen noch der Einsatz in Gasphasen-Dünnschichtverfahren bekannt.

Die erfindungsgemäßen Metallkomplexe umfassen auch Komplexe von Hauptgruppenmetallen des p-Blocks, speziell der 3., 4., 5. und 6. Periode des Periodensystems der Elemente. Diese werden von Hauptgruppenmetallatomen M mit einer Ordnungszahl von 12, 31 bis 34, 49 bis 52 oder 81 bis 83 gebildet. Besonders bevorzugte Metallatome M sind dabei Ga, Ge, As, Se, In, Sb, Te und Bi. Für erfindungsgemäße Komplexe dieser Hauptgruppenmetalle mit dem Liganden (hydra) wird ein selektiver, thermischer Zerfall über reduktive Eliminierung von R-(hydra) erwartet.

Im Gegensatz dazu gehen (hydra)-Metallkomplexe von Li oder Al regelmäßig keine reduktive Eliminierung von R-(hydra) ein. Für (hydra)-Metallkomplexe mit M = Li oder Al sind entsprechend weder reduktive Eliminierungen noch der Einsatz in Gasphasen-Dünnschichtverfahren bekannt.

Erfindungsgemäß ist es bevorzugt, dass in dem Metallkomplex M ausgewählt ist aus Ti, Co, Ga, Ge, As, Se, Ru, Pd, In, Sb, Te, Ir, Au und Bi, mehr bevorzugt ausgewählt aus Co, Ga, Ge, Ru, In und Ir. Ein solcher Metallkomplex kann dazu dienen, Substratoberflächen mit einem besonders vorteilhaften Metall zu beschichten. Ein solcher Metallkomplex kann bei einer derartigen Beschichtung zu besonders geringen Einbauraten von Kohlenstoff und anderen Verunreinigungen führen. Bei einem solchen Metallkomplex kann bei Zersetzung leichter eine reduktive Eliminierung von (hydra) unter Reduktion von Ti, Co, Ga, Ge, As, Se, Ru, Pd, In, Sb, Te, Ir, Au oder Bi erfolgen.

Erfindungsgemäß ist es bevorzugt, dass in dem Metallkomplex L¹ und L² unabhängig voneinander aus Cl, H, Methyl, Ethyl, Propyl, Isopropyl, tert-Butyl, Cyclopentadienyl, Methylcyclopentadienyl, Isopropylcyclopentadienyl, Aren, Phosphin, Isonitril und Carbonyl ausgewählt sind. Ein solcher Metallkomplex kann durch die ausgewählten Liganden flüchtig und bei Raumtemperatur flüssig sein. Ein solcher Metallkomplex kann durch die ausgewählten Liganden stabilisiert sein.

Mit "Aren" wird nach der *International Union of Pure and Applied* Chemistry ein aromatischer Kohlenwasserstoff bezeichnet. Arene sind p-azide Verbindungen. Arene umfassen sowohl monocyclische als auch polycyclische aromatische Kohlenwasserstoffe. Ein erfindungsgemäß eingesetztes Aren kann optional substituiert sein. Optionale Substituenten des Arens werden hier teilweise mit (R¹)ₘ bezeichnet. Der Index m kann bevorzugt 0, 1, 2, 3, 4, 5 oder 6 sein, mehr bevorzugt 0 oder 2, insbesondere bevorzugt 2. Erfindungsgemäß ist R¹ bevorzugt aus Kohlenwasserstoffresten, Hydroxygruppen, Alkoxygruppen, Aminogruppen und Halogenen ausgewählt, mehr bevorzugt aus Kohlenwasserstoffresten.

Im Rahmen der vorliegenden Erfindung bezieht sich ein Kohlenwasserstoffrest wie üblich auf einen Rest, der ausschließlich aus Kohlenstoff und Wasserstoff aufgebaut ist. Im Rahmen der vorliegenden Erfindung bezieht sich ein Kohlenwasserstoffrest allgemein auf einen Kohlenwasserstoffrest, der gesättigt oder ungesättigt sein kann. Bevorzugt sind gesättigte Kohlenwasserstoffreste. Im Rahmen der vorliegenden Erfindung bezieht sich ein Kohlenwasserstoffrest allgemein auf einen Kohlenwasserstoffrest, der linear, verzweigt oder cyclisch sein kann. Bevorzugt sind lineare und verzweigte Kohlenwasserstoffreste.

Erfindungsgemäß ist es bevorzugt, dass in dem Metallkomplex x = y = 1 ist, wobei optional z = 1 ist. Ein solcher Metallkomplex kann synthetisch leichter zugänglich sein. In einem solchen Metallkomplex können die Liganden L¹ und L² in Abhängigkeit vom Metallatom M geeignet ausgewählt sein, um den Metallkomplex einerseits zu stabilisieren und andererseits seine Flüchtigkeit zu gewährleisten. Bei einem solchen Metallkomplex kann bei Zersetzung leichter eine reduktive Eliminierung von (hydra) erfolgen.

Erfindungsgemäß ist es in einem Aspekt bevorzugt, dass für den Metallkomplex der Formel (I) gilt:
M = Ru,
L¹ = Aren, mit x = 1,
L² = Cl, H, Methyl, Ethyl, Propyl, Isopropyl oder tert-Butyl, mit y = 1,
z = 1, und
n = 1.
Ein solcher bevorzugter Metallkomplex hat die Formel (la).

Der Metallkomplex der Formel (Ia) kann sehr flüchtig und bei Raumtemperatur flüssig, aber bei höheren Temperaturen noch stabil sein. Der Metallkomplex der Formel (la) kann keine zu hohen Zersetzungstemperaturen aufweisen. Der Metallkomplex der Formel (la) kann synthetisch über wenige Stufen zugänglich sein. Bei dem Metallkomplex der Formel (la) kann bei Zersetzung leichter eine reduktive Eliminierung von (hydra) erfolgen.

Erfindungsgemäß ist es für den Metallkomplex der Formel (la) bevorzugt, dass das Aren ein mit 1 bis 6 (1,2,3,4,5,6) gleichen oder verschiedenen C₁-₈ (C_{1,2,3,4,5,6,7,8}) Kohlenwasserstoffresten substituiertes Aren oder ein unsubstituiertes Aren ist. Weiter bevorzugt ist das Aren aus 4-Isopropyltoluol und Benzol ausgewählt. 4-Isopropyltoluol wird auch als p-Cymol oder para-Cymol bezeichnet. Ohne Bindung an die Theorie wird erwartet, dass insbesondere das unsymmetrisch substituierte 4-Isopropyltoluol eine Kristallisation des Metallkomplexes der Formel (la) erschwert und seine Flüchtigkeit und Flüssigkeit bei Raumtemperatur verbessert.

Erfindungsgemäß ist es für den Metallkomplex der Formel (la) bevorzugt, dass L¹ = Benzol oder 4-Isopropyltoluol und L² = H, Methyl oder Ethyl ist.

Erfindungsgemäß ist es in einem anderen Aspekt bevorzugt, dass für den Metallkomplex der Formel (I) gilt:
M = In,
L¹ = Cl, H, Methyl, Ethyl, Propyl, Isopropyl oder tert-Butyl, mit x = 1,
L² = Cl, H, Methyl, Ethyl, Propyl, Isopropyl oder tert-Butyl, mit y = 1,
z = 1, und
n = 2.
Ein solcher bevorzugter Metallkomplex hat die Formel (Ib).

Der Metallkomplex der Formel (Ib) kann sehr flüchtig und bei Raumtemperatur flüssig, aber bei höheren Temperaturen noch stabil sein. Der Metallkomplex der Formel (Ib) kann keine zu hohen Zersetzungstemperaturen aufweisen. Der Metallkomplex der Formel (Ib) kann synthetisch über wenige Stufen zugänglich sein. Bei dem Metallkomplex der Formel (Ib) kann bei Zersetzung leichter eine reduktive Eliminierung von (hydra) erfolgen.

Erfindungsgemäß ist es für den Metallkomplex der Formel (Ib) bevorzugt, dass L¹ = H, Methyl oder Ethyl und L² = H, Methyl oder Ethyl ist.

Erfindungsgemäß ist es für den Metallkomplex allgemein, insbesondere für die Metallkomplexe der Formeln (la) und (Ib), bevorzugt, dass L² entweder H, Methyl, Ethyl, Propyl, Isopropyl oder tert-Butyl ist. Es ist mehr bevorzugt, dass L² entweder Methyl oder Ethyl ist. Wenn L² Ethyl ist, kann L² bei Zersetzung durch Abspaltung eines beta-H *in situ* zu einem Hydridoliganden (H) werden. Die Flüchtigkeit eines bevorzugten Metallkomplexes mit L² = H, Methyl, Ethyl, Propyl, Isopropyl oder tert-Butyl kann noch weiter verbessert sein. Eine reduktive Eliminierung von (hydra) aus einem bevorzugten Metallkomplex mit L² = Methyl oder Ethyl kann noch leichter erfolgen.

Der erfindungsgemäße Metallkomplex ist bevorzugt ein Metallkomplex der Formel (la) oder ein Metallkomplex der Formel (Ib).

Erfindungsgemäß besonders bevorzugte Metallkomplexe sind [RuCl(*p*-cymol)(hydra)], [RuMe(*p*-cymol)(hydra)] und [InMe₂(hydra)]₂.

Erfindungsgemäß ist es bevorzugt, dass in dem erfindungsgemäßen Metallkomplex das Metallatom M und der Ligand (hydra) einen Ring bilden. (hydra) koordiniert dabei entweder über zwei seiner Atome an dasselbe Metallatom M eines mononuklearen Metallkomplexes (n = 1), oder (hydra) koordiniert dabei über ein erstes seiner Atome an ein erstes Metallatom M und über ein zweites seiner Atome an ein zweites Metallatom M eines dinuklearen Metallkomplexes (n = 2).

Ohne Bindung an die Theorie wird angenommen, dass in erfindungsgemäßen mononuklearen Metallkomplexen (hydra) chelatisierend an M koordiniert. Ohne Bindung an die Theorie wird erwartet, dass je nach Härte von M (Härte gemäß der Definition von Pearson) bzw. dem Verhältnis von Ladung zu Radius von M die folgenden drei Koordinationsmodi auftreten:

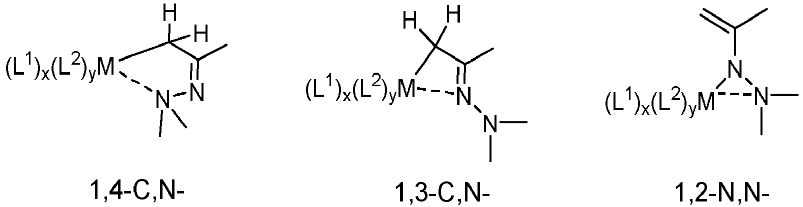

Abgebildet ist ein mononuklearer (hydra)-Metallkomplex eines Metalls M mit drei verschiedenen, chelatisierenden Koordinationsmodi. Dargestellt sind ein 1,4-C,N-Koordinationsmodus, ein 1,3-C,N-Koordinationsmodus und ein 1,2-N,N-Koordinationsmodus. Der Ligand (hydra) kann dazu beitragen, flüchtige und/oder metastabile Metallkomplexe zu stabilisieren. Ohne Bindung an die Theorie wird angenommen, dass der Ligand (hydra) flüchtige und/oder metastabile Metallkomplexe insbesondere über eine C∩N-Chelatring-Konfiguration stabilisieren kann. Die erhöhte Stabilität verbessert die Eignung entsprechender Metallkomplexe für Gasphasen-Dünnschichtverfahren. Die erhöhte Stabilität verbessert insbesondere die Eignung entsprechender Metallkomplexe für die Metallisierung von Substratoberflächen mittels CVD- oder ALD-Verfahren.

Erfindungsgemäß ist es bevorzugt, dass in dem Metallkomplex (hydra) über ein sp³-hybridisiertes N-Atom an M koordiniert ist. Eine solche Koordination kann in dem erfindungsgemäßen Metallkomplex eine C∩N-Chelatring-Konfiguration begünstigen. Eine C∩N-Chelatring-Konfiguration kann zu einer Stabilisierung des Metallkomplexes beitragen.

Erfindungsgemäß ist es gleichzeitig oder alternativ bevorzugt, dass in dem Metallkomplex (hydra) über ein sp²-hybridisiertes N-Atom an M koordiniert ist. Eine solche Koordination kann in dem erfindungsgemäßen Metallkomplex alternative Chelatring-Konfigurationen begünstigen. Alternative Chelatring-Konfigurationen können zu einer größeren strukturellen Vielfalt und damit einer größeren Variabilität der physikochemischen Eigenschaften der erfindungsgemäßen Metallkomplexe beitragen.

Erfindungsgemäß sind auch dinukleare Metallkomplexe umfasst, die neben den oben abgebildeten Koordinationsmodi davon abgeleitete, verbrückende (η-)Koordinationsmodi von (hydra) aufweisen. Beispielsweise kann (hydra) gleichzeitig an zwei Metallatome M mit bevorzugt gleicher Ordnungszahl koordinieren. Im Fall von zwei Metallatomen M gleicher Ordnungszahl ergibt sich ein homodinukleares Dimer. In einem solchen dinuklearen Metallkomplexe können die zwei Metallatomen M zusammen mit den (hydra)-Liganden zum Beispiel einen achtgliedrigen Ring bilden.

Erfindungsgemäß ist es bevorzugt, dass der Metallkomplex unter Standardbedingungen flüssig ist. Standardbedingungen sind eine Temperatur von 25°C und ein absoluter Druck von 1•10⁵ Pa. Der Aggregatzustand "flüssig" schließt eine ölige Konsistenz des Metallkomplexes ein. Flüssigkeit des Metallkomplexes unter Standardbedingungen kann die Eignung des Metallkomplexes für Gasphasen-Dünnschichtverfahren verbessern.

Erfindungsgemäß ist es bevorzugt, dass der Metallkomplex bei Temperaturen im Bereich von 100 bis 200°C, mehr bevorzugt im Bereich von 120 bis 180 °C, und noch mehr bevorzugt im Bereich von 140 bis 160°C zerfällt. Ein Zerfallen des Metallkomplexes bei diesen Temperaturen kann die Eignung des Metallkomplexes für Gasphasen-Dünnschichtverfahren verbessern.

Erfindungsgemäß ist es bevorzugt, dass ein Einsetzen eines Zerfalls eines erfindungsgemäßen Metallkomplexes durch thermische Analyse bestimmt wird. Die thermische Analyse ist bevorzugt eine thermogravimetrische Analyse (TGA). Die thermogravimetrische Analyse ist eine analytische Methode, bei der Masseänderungen einer Probe in Abhängigkeit von Temperatur und Zeit gemessen werden. Bei der thermogravimetrischen Analyse wird die Probe in einem Tiegel erhitzt. Eine Halterung des Tiegels ist an eine Waage gekoppelt, welche Masseänderungen während des Aufheizvorgangs registriert. Kommt es beim Aufheizvorgang zu einem Masseabbau, kann dies den Zerfall der Probe anzeigen.

Die TGA erfolgt zum Beispiel in einem Temperaturbereich von 25°C bis 800°C. Die Aufheizgeschwindigkeit bei der TGA beträgt typischerweise 10°C/min. Der durch Verdampfung und/oder Zersetzung bedingte Masseabbau wird bevorzugt über TGA und über eine simultane Differenz-Thermoanalyse (SDTA) verfolgt. Die SDTA bestimmt den Wärmefluss anhand von endothermen Peaks (z.B. Schmelzpunkt, Verdampfung aus der flüssigen Phase, Sublimation unterhalb des Schmelzpunktes) bzw. von exothermen Peaks (z.B. exotherme Zersetzungsreaktion). Ein endothermer Peak ohne Masseverlust entspricht regelmäßig einem Schmelzpunkt. Ein endothermer Peak mit Masseverlust entspricht regelmäßig einer Verdampfung. Ein exothermer Peak mit Masseverlust entspricht regelmäßig einer Zersetzung. Über Onset-Werte lassen sich diese Kenngrößen experimentell bestimmen. Es kann zum Beispiel die Temperatur einer TGA/SDTA angegeben werden, bei der die Masse der untersuchten Probe des Metallkomplexes um 3 Gew.-% abgebaut ist (3% Abbau). Es kann ergänzend zum Beispiel die Temperatur (T_{MA}) einer TGA/SDTA angegeben werden, bei der es nach dem anfänglichen Abbau der Masse der untersuchten Probe um 3 Gew.-% zu einem weiteren Masseabbau kommt.

Erfindungsgemäß ist es bevorzugt, dass in einer thermogravimetrischen Analyse die Temperatur des ersten Masseabbaus von 3 Gew.-% des Metallkomplexes bei 1•10⁵ Pa im Bereich von 100 bis 200°C, mehr bevorzugt im Bereich von 120 bis 180°C und noch mehr bevorzugt im Bereich von 140 bis 160°C liegt. Erfindungsgemäß ist es bevorzugt, dass es im Anschluss an den ersten Masseabbau von 3 Gew.-% in einer thermogravimetrischen Analyse bei 1•10⁵ Pa im Bereich von T_{MA} = 160 bis 200°C zu einem weiteren Masseabbaus des Metallkomplexes kommt.

Gegenstand der Erfindung ist auch ein Verfahren zur Herstellung eines erfindungsgemäßen Metallkomplexes umfassend die Schritte:
(i) Umsetzen von Acetondimethylhydrazon mit einer Li-organischen Verbindung zur Herstellung von Li(hydra),
(ii) Umsetzen von Li(hydra) mit einer Verbindung mit der Formel [ML¹ₓ₁L²_{y1}]ₙ₁, mit x₁ = 0, 1 oder 2, y₁ = 0, 1 oder 2, n₁ = 1 oder 2, zur Herstellung einer Verbindung mit der Formel [M(L¹)ₓ(L²)_{y}(hydra)_{z}]ₙ.

Das erfindungsgemäße Verfahren kann einen erfindungsgemäßen Metallkomplex mit den oben genannten erwünschten Eigenschaften in einer einfachen Synthese unter milden Bedingungen und über wenige Stufen im industriellen Maßstab bei hohen Ausbeuten bereitstellen.

Erfindungsgemäß ist es bevorzugt, dass in dem erfindungsgemäßen Verfahren L² entweder H, Methyl, Ethyl, Propyl, Isopropyl oder tert-Butyl ist oder im Anschluss an Schritt (ii) in einem Schritt (iii) in H, Methyl, Ethyl, Propyl, Isopropyl oder tert-Butyl überführt wird. Der Ligand L² kann in diesen Fällen synthetisch leicht in den erfindungsgemäßen Metallkomplex eingeführt werden. Der Ligand L² kann in diesen Fällen Metallkomplexe mit vorteilhafter Neigung zur reduktiven Eliminierung von (hydra) bei Zersetzung liefern.

Gegenstand der Erfindung ist auch eine Verwendung eines erfindungsgemäßen Metallkomplexes zur Abscheidung des Metalls in einem CVD-Verfahren oder einem ALD-Verfahren.

Durch diese erfindungsgemäße Verwendung kann das Metall in Form dünner Schichten abgeschieden werden. Dabei kann ein Einbau von Kohlenstoff und anderen Verunreinigungen minimiert oder vermieden werden.

Gegenstand der Erfindung ist auch ein Verfahren, in dem ein erfindungsgemäßer Metallkomplex als Präkursor zur Herstellung einer Schicht aus dem Metall verwendet wird.

Durch dieses erfindungsgemäße Verfahren kann die Schicht aus Metall in Form einer dünnen Schicht hergestellt werden. Dabei kann ein Einbau von Kohlenstoff und anderen Verunreinigungen minimiert oder vermieden werden.

Gegenstand der Erfindung ist auch eine metallisierte Oberfläche, erhältlich durch Abscheiden eines Metalls auf einer Oberfläche aus einer Gasphase, die einen erfindungsgemäßen Metallkomplex umfasst.

Erfindungsgemäß kann dadurch eine metallisierte Oberfläche bereitgestellt werden, bei der ein Einbau von Kohlenstoff und anderen Verunreinigungen minimiert oder ganz vermieden ist.

### Allgemeine Synthesewege

Acetondimethylhydrazon (H-hydra) ist literaturbekannt.^{[5]-[7]} H-hydra kann über eine einfache Kondensationsreaktion aus Aceton und N,N-Dimethylhydrazin dargestellt werden.

In der vorliegenden Erfindung kann die Darstellung von H-hydra zum Beispiel über eine Umsetzung äquimolarer Mengen an Aceton und *N*,*N*-Dimethylhydrazin unter Zugabe von MgSO₄ zum Abfangen von entstehendem H₂O erfolgen. Das Gemisch kann zum Beispiel für 7 Stunden unter Rückflussbedingungen (Reflux) erhitzt werden:

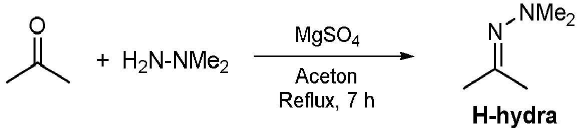

H-hydra ist eine nicht luftempfindliche, destillierbare Flüssigkeit und CH-Säure. In der vorliegenden Erfindung wird H-hydra bevorzugt in den deprotonierten (lithiierten) Ligand Li(hydra) überführt. Die Deprotonierung von H-hydra kann *in situ* erfolgen. Dazu wird H-hydra zum Beispiel in THF vorgelegt. H-hydra kann dann zum Beispiel mit n-BuLi deprotoniert werden. Derartige Umsetzungen *in situ* sind bekannt.^{[7]-[9]}

Erfindungsgemäß ist es bevorzugt, dass die Darstellung von Li(hydra) durch Vorlage von H-Hydra in nHexan bei 0 °C unter tropfenweiser Zugabe einer nBuLi-Lösung erfolgt. Der entstehende Feststoff kann mittels Filtration abgetrennt und im Feinvakuum getrocknet werden. Regelmäßig wird ein Isomerengemisch von Li(hydra) erhalten:

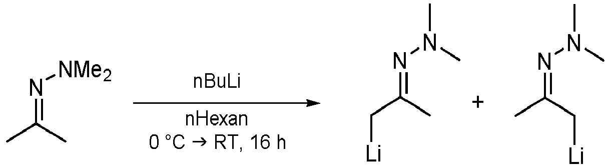

Ohne Bindung an die Theorie ist erfindungsgemäß eingeschlossen, dass die nachfolgend beschriebene N-Amino-enamid-Form bzw. Enhydrazid-Form in einem solchen Isomerengemisch vorliegt:

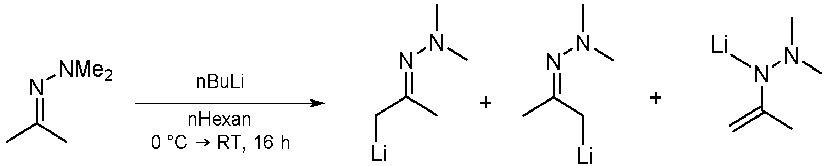

Erfindungsgemäß dient der deprotonierte (lithiierte) Ligand Li(hydra) nachfolgend der Darstellung erfindungsgemäßer Hydra-Metallkomplexe.

Beispielhaft werden Darstellungen von Metallkomplexen der Formel [(Aren)RuCl(hydra)] beschrieben (der Aren-Ligand ist bevorzugt Benzol oder para-Cymol):
Li(hydra) wird in Toluol bei 0 °C vorgelegt. Die Verbindung [RuCl₂(Aren)]₂ wird dort zugegeben. Die Aufarbeitung erfolgt durch Entfernen des Lösungsmittels im Feinvakuum. Der Rückstand wird in nHexan aufgenommen. Danach wird über Celite® filtriert. Das Filtrat wird im Feinvakuum eingetrocknet. Die Zielverbindung wird aus dem Rückstand durch Sublimation im Feinvakuum bei 120 °C isoliert. Es kann das folgende beispielhafte Reaktionschema angegeben werden:

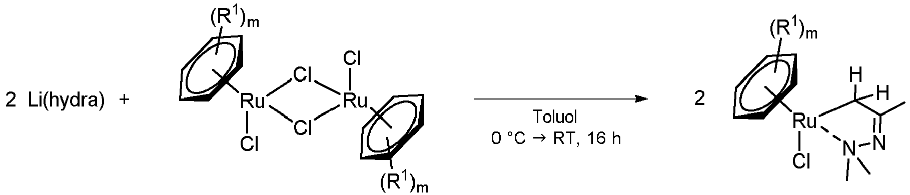

Erfindungsgemäß kann der Chlorido-Ligand am Ruthenium nachfolgend bevorzugt substituiert werden. Die Substitution kann mit äquimolaren Mengen an MeLi zwecks Einführung einer Methyl-Gruppe erfolgen. Die Substitution kann mit 0,3 Äquivalenten LiAlH₄ zwecks Einführung eines Hydrido-Liganden erfolgen. In beiden Fällen kann wie folgt aufgearbeitet werden: Entfernen des Lösungsmittels im Feinvakuum, Aufnahme des Rückstands in nHexan, Filtration über Celite®, Eintrocknen des Filtrats im Feinvakuum (FV) und Isolieren der Zielverbindungen mittels Umkondensation (FV/100 °C) aus den erhaltenen Rückständen. Es kann das folgende beispielhafte Reaktionschema angegeben werden:

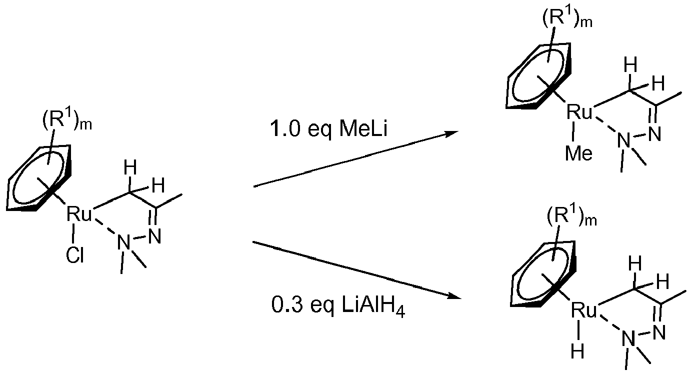

Auf analoge Weise können die folgenden Komplexgruppen und Komplexe synthetisiert werden:
[Ru(η⁶-Aren^{R})R²(hydra)], mit:
   Aren^{R} = substituiertes Aren, R² = Hydrido, Methyl, Ethyl, Chlorido
[Ru(η⁵-Cp^{R})L^{N}(hydra)], mit:
   Cp^{R} = substituiertes Cyclopentadienyl,
   L^{N} = 2-Elektronen-Neutralligand, bevorzugt CO, CNMe, PH₃
[Co(hydra)₂]; [InMe₂(η-hydra)]₂ bzw. [Me₂In(η-hydra)₂InMe₂]; [GeH₂(hydra)₂]; [Bi(hydra)₃]

Die erfindungsgemäß darstellbaren Metallkomplexe mit (hydra)-Ligand sind regelmäßig metastabile, flüchtige und gut verdampfbare Komplexe. Sie eignen sich daher in besonderer Weise als Präkursoren in Gasphasen-Dünnschichtverfahren wie CVD und ALD. Der hier beispielhaft angegebenen, bevorzugten Synthesewege liefern preisgünstige, leicht zugängliche und im großen Maßstab analysenrein isolierbare Metallkomplexe.

### Anwendungen für die erfindungsgemäßen Komplexe

Die erfindungsgemäßen Metallkomplexe finden Verwendung als Präkursoren für Metalle bzw. Metallschichten. Insbesondere können sie zur Herstellung von Dünnschichten aus einem Metall mittels Gasphasen-Dünnschichtverfahren wie CVD und ALD dienen.

Gasphasen-Dünnschichtverfahren umfassen eine Gasphasenreaktion, die in der Regel an oder in der Nähe einer Oberfläche eines Substrats abläuft. Dabei werden an der Reaktion beteiligte Reaktanten bzw. Präkursoren in Form von Gasen dem zu beschichtenden Substrat zugeleitet. Das Substrat ist dabei in einer Reaktionskammer angeordnet und wird beheizt. Die meist vorgeheizten Gase werden durch das beheizte Substrat thermisch aktiviert und reagieren miteinander bzw. dem Substrat. In den Gasen enthaltene Präkursoren werden durch das beheizte Substrate thermisch zersetzt. Dadurch wird das erwünschte Material abgeschieden und chemisch gebunden. Es kommt zu einer Chemisorption des erwünschten Materials, in der vorliegenden Erfindung des Metalls mit der Ordnungszahl ausgewählt aus den Bereichen a) 21 bis 33, mit Ausnahme von 30, b) 39 bis 51, mit Ausnahme von 48, und c) 71 bis 83, mit Ausnahme von 80.

Das ALD-Verfahren, auch als Atomlagenabscheidung bezeichnet, ist ein verändertes CVD-Verfahren. Beim ALD-Verfahren endet die Reaktion bzw. Sorption an der Oberfläche nach der vollständigen Belegung der Oberfläche von sich aus. Diese selbstbegrenzende Reaktion wird in mehreren Zyklen durchlaufen, die von dazwischenliegenden Spülschritten begrenzt werden. Auf diese Weise werden sehr exakte Schichtdicken erreicht.

Wie oben beschrieben sind die erfindungsgemäßen Metallkomplexe durch eine wenig aufwändige technische Synthese darstellbar. Die einfache technische Synthese ist ein wichtiger Vorteil bei einer industriellen Anwendung der erfindungsgemäßen Metallkomplexe in Prozessen der Gasphasenabscheidung. Ein weiterer wichtiger Grund für die besondere Eignung der erfindungsgemäßen Metallkomplexe für CVD- und/oder ALD-Verfahren liegt darin, dass die erfindungsgemäßen Metallkomplexe flüchtige, teils bei Raumtemperatur flüssige Verbindungen sind. Zudem lassen sie sich erfolgreich zu dem entsprechenden elementaren Metall zersetzen. Sie stellen damit für die Abscheidung solcher elementaren Metalle eine vorteilhafte Alternative zu bekannten Präkursoren für die entsprechenden Metalle dar.

### Ausführungsbeispiele

In den nachfolgenden Beispielen bedeutet:
- H-hydra: Acetondimethylhydrazon
- hydra: Acetondimethylhydrazon-Anion
- *p*-cymol: 4-Isopropyltoluol

### Beispiel 1 - Darstellung von H-hydra

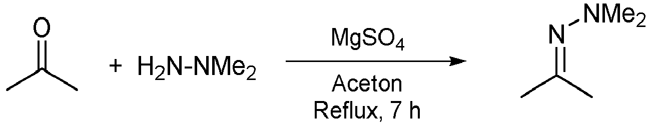

MgSO₄ (15.0 g) wurde in Aceton (50 mL, *exc*.) vorgelegt und die Suspension unter Rühren mit *N*,*N*-Dimethylhydrazin (16.4 g/20.6 mL, 272 mmol, 1.0 eq) versetzt. Das Gemisch wurde für 7 Stunden unter Rückflussbedingungen erhitzt und anschließend über einen Faltenfilter filtriert. Nach Extraktion des Feststoffs mit Aceton (15 mL) wurde das Filtrat im Vakuum vom Lösungsmittel befreit und Acetondimethylhydrazon dabei als farblose Flüssigkeit (14.8 g, 147 mmol, 54%) erhalten.

| | |
|---|---|
| ¹H-NMR | CDCl₃, 300.2 MHz: *δ* / ppm = 2.39 (s, 6 H, NMe₂), 1.93 (s, 3 H, Me), 1.88 (s, 3 H, Me). |
| ¹H-NMR | C₆D₆, 300.2 MHz: *δ* / ppm = 2.39 (s, 6 H, NMe₂), 1.70 (s, 3 H, Me), 1.70 (s, 3 H, Me). |
| ¹³C-NMR | C₆D₆, 75.5 MHz: *δ* / ppm = 163.5 (C_{q}), 47.2 (NMe₂), 24.9 (Me), 17.6 (Me). |
| HR-EI(+)-MS | Berechnet für [M+H]⁺ = 101.1073 m/z, gefunden: 101.1071 m/z. |

### Beispiel 2 - Darstellung von Li(hydra)

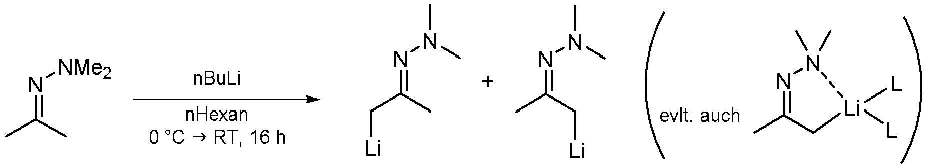

Acetondimethylhydrazon (14.8 g, 147 mmol, 1.0 eq) wurde mit nHexan (100 mL) versetzt und das Gemisch auf 0 °C gekühlt. Über einen Tropftrichter erfolgte die Zugabe einer nBuLi-Lösung (2.43 M in *n*Hexan, 60.5 mL, 147 mmol, 1.0 eq) über einen Zeitraum von zwei Stunden, wobei das Ausfallen eines farblosen Feststoffs beobachtet wurde. Das Gemisch wurde über Nacht gerührt, wobei es sich auf Raumtemperatur erwärmen konnte. Der entstandene Feststoff wurde mittels Filtration abgetrennt, mit nHexan (30 mL) gewaschen und abschließend im Vakuum getrocknet. Li(hydra) konnte als farbloser Feststoff erhalten werden.

| | |
|---|---|
| ¹H-NMR | (THF-*d₈*, 300.2 MHz): *δ* / ppm = 1.98 (s, 6 H, NMe₂), 1.56 (s, 2.5 H, CH_{2.5}), 1.48 (s, 2.5 H, CH_{2.5}). |
| ¹H-NMR | (Toluol-*d₈*, 300.2 MHz): *δ* / ppm = 2.37 (s, 6 H, NMe₂), 1.70 (s, 5 H, CH₂ + CH₃). |
| ¹³C-NMR | (THF-*d₈*, 75.5 MHz): *δ* / ppm = 163.6 (C_{q}), 47.2 (NMe₂), 17.5 (Me). |
| ⁷Li-NMR | (THF-*d₈*, 116.7 MHz): *δ* / ppm = 1.37 (s), 0.53 (s). |
| Elementaranalyse | C5H₁₁ N₂Li (106.10 g/mol) |
| | berechnet: C: 56.60%, H: 10.45%, N: 26.40% |
| | gefunden: C: 54.29%, H: 9.41%, N: 24.21%. |

### Beispiel 3 - Darstellung von [RuCl(p-cymol)(hydra)]

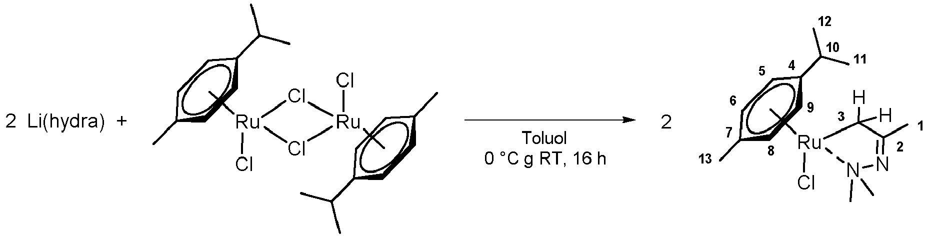

Li(hydra) (200 mg, 0.94 mmol, 2.0 eq) wurde in Toluol (25 mL) bei 0 °C vorgelegt und mit [RuCl₂(*p*-cymol)]₂ (289 mg, 0.47 mmol, 1.0 eq) versetzt. Das Gemisch wurde für 16 Stunden gerührt, wobei es Raumtemperatur erreichen konnte und eine tiefrote Farbe annahm. Anschließend wurde die Reaktionslösung über Celite® filtriert, der Filterkuchen mit weiteren Mengen an Toluol (10 mL) extrahiert und das erhaltene Filtrat im Feinvakuum von allen flüchtigen Bestandteilen befreit. [RuCl(*p*-cymol)(hydra)] konnte abschließend mittels Sublimation (FV/120 °C) aus dem Rückstand als dunkelroter Feststoff (20.1 mg, 56.4 µmol, 12%) isoliert werden.

| | |
|---|---|
| ¹H-NMR | (C₆D₆, 300.2 MHz): 4.74 (d, ³*J*_{HH} = 5.6 Hz, 1 H, H-5), 4.45 (d, ³*J*_{HH} = 5.8 Hz, 1 H, H-6), 4.18 (d, ³*J*_{HH} = 5.6 Hz, 1 H, H-9), 3.91 (d, ³*J*_{HH} = 5.8 Hz, 1 H, H-8), 3.46 (d, ²*J*_{HH} = 15.6 Hz, 2 H, H-3), 3.28 (s, 3 H, H-13), 3.20 (d, ²*J*_{HH} = 15.6 Hz, 1 H, H-3), 2.73 (sept, 1 H, H-10), 2.24 (s, 3 H, NMe₂), 2.01 (s, 3 H, H-1), 1.71 (s, 3 H, NMe₂), 1.16 (d, ³*J*_{HH} = 6.9 Hz, 3 H, H-11/12), 1.07 (d, ³*J*_{HH} = 7.1 Hz, 3 H, H-11/12). |
| ¹³C-NMR | (C₆D₆, 75.5 MHz): *δ* / ppm = 181.5 (C-2), 108.5 (C-4), 93.0 (C-7), 82.5 (C-6/8), 81.3 (C-5/9), 80.8 (C-6/8), 79.7 (C-5/9), 59.3 (NMe₂), 56.1 (NMe₂), 37.8 (C-3), 31.2 (C-10), 23.3 (C-11/12), 22.0 (C-11/12), 21.4 (C-1), 17.9 (C-13). |
| HR-EI(+)-MS | berechnet für: [M]⁺ = 370.0750 m/z, gefunden: 370.0881 m/z. |
| Elementaranalyse | C₁₅H₂₅N₂ClRu (369.90 g/mol) |
| | berechnet: C: 48.71%, H: 6.81%, N: 7.57% |
| | gefunden: C: 49.50%, H: 6.80%, N: 8.67%. |
| TGA | (T_{S} = 25 °C, T_{E} = 800 °C, 10 °C/min, m = 5.05 mg) Stufen: 2, T = 156.1 °C (3% Abbau), T_{MA} = 184.0 °C (1. Prozess), T_{MA} = 262.0 (2. Prozess), Gesamtmasseabbau: 3.73 mg (73.8%). |
| SDTA | (T_{S} = 25 °C, T_{E} = 800 °C, 10 °C/min, m = 5.05 mg) T_{M}(Onset) = 88.4 °C, T_{M}(max) = 98.4 °C (endotherm), T_{D1}(Onset) = 163.2 °C, T_{D1}(max) = 180.3 °C (exotherm), T_{D2}(Onset) = 252.3 °C, T_{D2}(max) = 263.0 °C (exotherm). |

### Beispiel 4 - Darstellung von [RuMe(p-cymol)(hydra)]

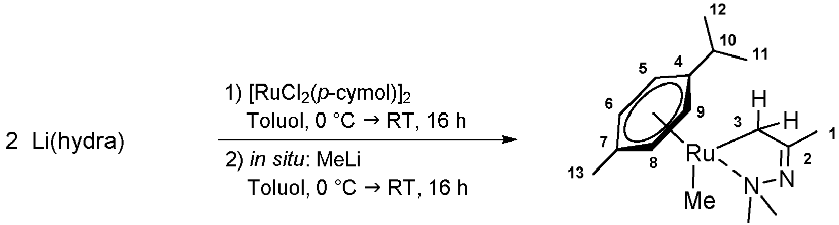

Li(hydra) (200 mg, 0.94 mmol, 2.0 eq) wurde in Toluol (25 mL) bei 0 °C vorgelegt und mit [RuCl₂(*p*-cymol)]₂ (289 mg, 0.47 mmol, 1.0 eq) versetzt. Das Gemisch wurde für 16 Stunden gerührt, wobei es Raumtemperatur erreichen konnte und eine tiefrote Farbe annahm. Die Zugabe von MeLi (0.94 mmol, 2.0 eq) erfolgte *in situ* bei 0 °C. Nach einer Reaktionszeit von 16 Stunden, bei welcher das Gemisch Raumtemperatur erreichen konnte, wurden alle flüchtigen Bestandteile im Feinvakuum entfernt. Der erhaltene Rückstand wurde in nHexan (10 mL) aufgenommen, über Celite® filtriert und der Filterkuchen mit weiteren Mengen an nHexan (10 mL) extrahiert. Nach Eintrocknen des Filtrats im Feinvakuum konnte [RuMe(*p*-cymol)(hydra)] im Feinvakuum bei 110 °C aus dem Rückstand als gelbes Öl herauskondensiert werden.

| | |
|---|---|
| ¹H-NMR | (C₆D₆, 300.2 MHz): 4.27-4.21 (m, 3 H, H-5, H-9, H-8), 4.05 (d, ³*J*_{HH} = 5.5 Hz, H-6), 3.34 (d, ²*J*_{HH} = 16.5 Hz, H-3), 2.66 (s, 3 H, NMe₂), 2.49 (sept, 1 H, H-10), 2.48 (s, 3 H, NMe₂), 2.11 (d, ²*J*_{HH} = 16.7 Hz, H-3), 2.06 (s, 3 H, H-1), 1.89 (s, 3 H, H-13), 1.12 (d, ³*J*_{HH} = 6.8 Hz, H-11, H-12), 0.46 (s, 3 H, RuMe). |
| HR-EI(+)-MS | berechnet für: [M]⁺ = 370.0750 m/z, gefunden: 370.0881 m/z. |
| TGA | (T_{S} = 25 °C, T_{E} = 600 °C, 10 °C/min, m = 9.70 mg) Stufen: 1, T = 146.1 °C (3%-Abbau), T_{MA} = 179.8 °C, Gesamtmasseabbau: 6.12 mg (63.0%). |
| SDTA | (T_{S} = 25 °C, T_{E} = 600 °C, 10 °C/min, m = 9.70 mg) T_{D}(Onset) = 161.9 °C, T_{D}(max) = 178.2 °C (exotherm). |

### Beispiel 5 - Darstellung von [InMe₂(hydra)]₂

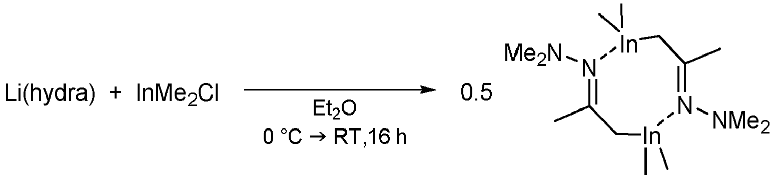

Li(hydra) (300 mg, 2.83 mmol, 1.0 eq) und InMe₂Cl (510 mg, 2.83 mmol, 1.0 eq) wurden zusammen vorgelegt, auf 0 °C gekühlt und mit kaltem Et₂O (0 °C, 15 mL) versetzt. Das Gemisch wurde für 5 Stunden bei 0 °C gerührt und konnte sich anschließend innerhalb von 16 Stunden auf Raumtemperatur erwärmen. Die Suspension wurde über Celite® filtriert und der Filterkuchen mit weiteren Mengen an Et₂O (10 mL) extrahiert. Das Filtrat wurde im Feinvakuum vom Lösungsmittel befreit und das zurückbleibende gelbe Öl mehrmals gefriergetrocknet. Das viskose Öl wurde anschließend im Feinvakuum bei 120 °C umkondensiert. Dabei konnte ebenfalls ein zähes Öl isoliert werden, aus welchem farblose Kristalle der dinuklearen Zielverbindung auskristallisierten.

| | |
|---|---|
| ¹H-NMR | (C₆D₆, 300.2 MHz): 2.13 (s, 6 H, NMe₂), 1.92 (s, 3 H, CH₃), 1.28 (s, 2 H, CH₂), -0.11 (s, 6 H, InMe₂). |
| HR-EI(+)-MS | berechnet für [InMe₂]⁺: m/z = 144.9508, |
| | gefunden: m/z = 144.9536. |
| | berechnet für [C₆H₁₄N₂ ≡ hydra]⁺: m/z = 114.1157, |
| | gefunden: m/z = 114.9082. |
| | berechnet für [C₂H₆N ≡ NMe₂]⁺: m/z = 44.0500, |
| | gefunden: m/z = 43.9963. |

Durch Einkristallröntgenstrukturanalyse konnte ermittelt werden, dass es sich um einen homodinuklearen Indiumkomplex mit einem verbrückenden C,N-Koordinationsmodus handelt. Der Komplex dieses Beispiels kann entsprechend seiner Struktur auch mit der folgenden Formel angegeben werden: [Me₂In(η-hydra)₂InMe₂].

### Literatur

[1] T. Fujisawa, M. Takeuchi, T. Sato, Chemistry Letters, 1982, 1521-1524
[2] D. J. Cárdenas, A. M. Echavarren, A. Vegas, Organometallics 1994, 13, 882-889
[3] S. Javed, D. M. Hoffman, Inorganic Chemisty 2008, 47, 11984-11992
[4] S. Javed, D. M. Hoffman, Eur. J. Inorg. Chem. 2008, 47, 5251-5256
[5] R. H. Wiley, S. C. Slaymaker, H. Kraus, J. Org. Chem. 1957, 22, 204-207
[6] C. Qi, F. Hasenmaile, V. Gandon, D. Laboef, ACS Catalysis 2018, 8, 1734-1739
[7] E. J. Corey, D. Enders, Chem. Ber. 1978, 111, 1362-1383.
[8] P.Y. Géant, E. Grenet, J. Martinez, X. J. Salom-Roig, Tetrahedron Asymmetry 2016, 27, 22-30,
[9] D. Enders, W. Dahmen, E. Dederichs, W. Gatzweiler, P. Weuster, Synthesis (Stuttg). 1990, 11, 1013-1019.

## Patentansprüche

1. Metallkomplex der Formel (I):
[M(L¹)ₓ(L²)_{y}(hydra)_{z}]ₙ Formel (I)
wobei:
M = Metallatom mit einer Ordnungszahl ausgewählt aus den Bereichen a) bis c):
a) 12, 21 bis 34, mit Ausnahme von 30,
b) 39 bis 52, mit Ausnahme von 48,
c) 71 bis 83, mit Ausnahme von 80,
L¹ = neutraler oder anionischer Ligand, mit x = 0 oder 1,
L² = neutraler oder anionischer Ligand, mit y = 0 oder 1,
(hydra) = Acetondimethylhydrazon-Monoanion, mit z = 1, 2 oder 3,
n = 1 oder 2 ist, und
die Gesamtladung des Komplexes 0 ist.

2. Metallkomplex gemäß mindestens einem der vorhergehenden Ansprüche, wobei M ausgewählt ist aus Ti, Co, Ga, Ge, As, Se, Ru, Pd, In, Sb, Te, Ir, Au und Bi, bevorzugt ausgewählt ist aus Co, Ga, Ge, Ru, In und Ir.

3. Metallkomplex gemäß mindestens einem der vorhergehenden Ansprüche, wobei L¹ und L² unabhängig voneinander aus Cl, H, Methyl, Ethyl, Propyl, Isopropyl, tert-Butyl, Cyclopentadienyl, Methylcyclopentadienyl, Isopropylcyclopentadienyl, Aren, Phosphin, Isonitril und Carbonyl ausgewählt sind.

4. Metallkomplex gemäß mindestens einem der vorhergehenden Ansprüche, wobei x = y = 1 ist, wobei optional z = 1 ist.

5. Metallkomplex gemäß Anspruch 1, wobei
M = Ru,
L¹ = Aren, mit x = 1,
L² = Cl, H, Methyl, Ethyl, Propyl, Isopropyl oder tert-Butyl, mit y = 1,
z = 1, und
n = 1 ist.

6. Metallkomplex gemäß Anspruch 5, wobei das Aren ein mit 1 bis 6 gleichen oder verschiedenen C₁-C₈ Kohlenwasserstoffresten substituiertes Aren oder ein unsubstituiertes Aren ist.

7. Metallkomplex gemäß Anspruch 6, wobei das Aren aus 4-Isopropyltoluol und Benzol ausgewählt ist.

8. Metallkomplex gemäß Anspruch 1, wobei
M = In,
L¹ = Cl, H, Methyl, Ethyl, Propyl, Isopropyl oder tert-Butyl, mit x = 1,
L² = Cl, H, Methyl, Ethyl, Propyl, Isopropyl oder tert-Butyl, mit y = 1,
z = 1, und
n = 2 ist.

9. Metallkomplex gemäß mindestens einem der vorhergehenden Ansprüche, wobei L² aus Methyl und Ethyl ausgewählt ist.

10. Metallkomplex gemäß Anspruch 1, ausgewählt aus [RuCl(*p*-cymol)(hydra)], [RuMe(*p-*cymol)(hydra)] und [InMe₂(hydra)]₂.

11. Verfahren zur Herstellung eines Metallkomplexes gemäß mindestens einem der vorhergehenden Ansprüche umfassend die Schritte:
(i) Umsetzen von Acetondimethylhydrazon mit einer Li-organischen Verbindung zur Herstellung von Li(hydra),
(ii) Umsetzen von Li(hydra) mit einer Verbindung mit der Formel [ML¹ₓ₁L²_{y1}]ₙ₁, mit x₁ = 0, 1 oder 2, y₁ = 0, 1 oder 2, n₁ = 1 oder 2, zur Herstellung einer Verbindung mit der Formel [M(L¹)ₓ(L²)_{y}(hydra)_{z}]ₙ.

12. Verfahren gemäß Anspruch 11, wobei L² entweder H, Methyl, Ethyl, Propyl, Isopropyl oder tert-Butyl ist oder im Anschluss an Schritt (ii) in einem Schritt (iii) in H, Methyl, Ethyl, Propyl, Isopropyl oder tert-Butyl überführt wird.

13. Verwendung eines Metallkomplexes gemäß mindestens einem der Ansprüche 1 bis 10 zur Abscheidung des Metalls in einem CVD-Verfahren oder einem ALD-Verfahren.

14. Verfahren, in dem ein Metallkomplex gemäß mindestens einem der Ansprüche 1 bis 10 als Präkursor zur Herstellung einer Schicht aus dem Metall verwendet wird.

15. Metallisierte Oberfläche, erhältlich durch Abscheiden eines Metalls auf einer Oberfläche aus einer Gasphase, die einen Metallkomplex gemäß mindestens einem der Ansprüche 1 bis 10 umfasst.
